# EUROPEAN PATENT SPECIFICATION

(11) **EP 4 454 223 B1**
(45) Date of publication and mention of the grant of the patent: **14.10.2026**
(21) Application number: 21968525.2
(22) Date of filing: 22.12.2021
(51) Int. Cl.: H04L 25/03, H03F 1/32, H03F 3/189, H03F 3/24

(54) **DIGITAL PRE-DISTORTER FOR NON-LINEAR ELECTRONIC DEVICES**
DIGITALER VORVERZERRER FÜR NICHTLINEARE ELEKTRONISCHE VORRICHTUNGEN
GÉNÉRATEUR DE PRÉDISTORSION NUMÉRIQUE POUR DISPOSITIFS ÉLECTRONIQUES NON LINÉAIRES

(43) Date of publication of application: 30.10.2024
(73) Proprietor: Telefonaktiebolaget LM Ericsson (publ), 164 83 Stockholm (SE)
(72) Inventor: DIKMESE, Sener, 174 61 Sundbyberg (SE); GAO, Hao, Beijing 100102 (CN); FENG, Ang, 169 56 Solna (SE)
(74) Representative: Ericsson
(86) International application number: PCT/CN2021/140366
(87) International publication number: WO 2023/115376

(56) References cited:
- WO-A1-2015/107392
- WO-A1-2021/251852
- CN-A- 103 201 949
- CN-A- 103 201 950
- US-A1- 2008 130 789
- US-A1- 2018 375 480
- GILABERT PERE L ET AL: "Spectral Weighting Orthogonal Matching Pursuit Algorithm for Enhanced Out-of-Band Digital Predistortion Linearization", IEEE TRANSACTIONS ON CIRCUITS AND SYSTEMS II: EXPRESS BRIEFS, IEEE, USA, vol. 66, no. 7, 3 October 2018 (2018-10-03), pages 1277 - 1281, XP011732420, ISSN: 1549-7747, [retrieved on 20190625], DOI: 10.1109/TCSII.2018.2878581
- LAHBIB NOURA DERRIA ET AL: "Massive MIMO Uplink Channel Estimation using Compressive Sensing", 2019 INTERNATIONAL CONFERENCE ON SOFTWARE, TELECOMMUNICATIONS AND COMPUTER NETWORKS (SOFTCOM), UNIVERSITY OF SPLIT, FESB, 19 September 2019 (2019-09-19), pages 1 - 6, XP033661895, DOI: 10.23919/SOFTCOM.2019.8903860

## Description

### TECHNICAL FIELD

Embodiments presented herein relate to a method, a digital pre-distorter for a nonlinear electronic device, a computer program, and a computer program product for operating the digital pre-distorter for the non-linear electronic device.

### BACKGROUND

Some electronic devices exhibit non-linear input-output characteristics and are therefore referred to as non-linear electronic devices. Non-linear electronic devices can be found in many types of electronic equipment, such as transmitters, receivers, transceivers, signal converters, and the like. Non-limiting examples of non-linear electronic devices are radio frequency (RF) amplifiers, power amplifiers (PAs), lownoise amplifiers (LNAs), etc.

In some scenarios the non-linear behaviour caused by the non-linear input-output characteristics is undesired and efforts are therefore made to make the non-linear input-output characteristics linear, and thus to linearize the non-linear electronic device. One way to linearize the non-linear electronic device is to connect the output of a linearizer device to the input of the non-linear electronic device such that the input to the non-linear electronic device is fed, and processed by, the linearizer device.

A digital pre-distorter (DPD) is an example of a linearizer device and can thus be used to mitigate the spectrum regrowth for non-linear electronic devices. Typically, the DPD comprises an actuator, or pre-distorter, placed in the forward path to inverse the non-linear behavior of the non-linear electronic device, and an estimator, or adaptation, in a feedback path to determine the coefficients for the forward path. An observation receiver can be deployed in the feedback path to observe the output from the non-linear electronic device.

One type of model used by the DPD to model the non-linear behavior of the nonlinear electronic device is look-up table (LUT) based models, also known as piecewise models. The basis function (BF) of such models can be piecewise linear function or spline function. The non-linear characteristics of the non-linear electronic devices are sliced into many small pieces with respect to the input level. Each piece is represented by a linear function or spline function. A LUT model can be written as: $y \left(n\right) = {\sum }_{i} {\sum }_{j} {\sum }_{k} {F}_{k} \left(\left|x\left(n-i\right)\right|\right) x \left(n-j\right)$ (1) where *Fₖ*(·) is the BF that has non-zero value if |*x*(*n* - *i*)| belongs to a value of the piece indicated by *k,* and where *x(n)* is the input signal to the DPD and *y*(*n*) is the output signal from the DPD that is used as input to the non-linear electronic device instead of *x(n).*

One type of model used by the DPD to model the non-linear behavior of the nonlinear electronic device is general memory polynomial (GMP) models. The BF of the GMP models consists of time-delayed sample multiplied by a set of time-delayed power series. The power series are selected according to the inter-modulation (IM) terms. A GMP model can be written as: $y \left(n\right) = {\sum }_{i} {\sum }_{j} {\sum }_{k} {c}_{i , j , k} {\left|x\left(n-i\right)\right|}^{k} x \left(n-j\right)$ (2) where, *c_{í,j,k}* is the coefficient of GMP model, and where, as above, *x(n)* is the input signal to the DPD and *y*(*n*) is the output signal from the DPD that is used as input to the non-linear electronic device instead of *x(n).*

GMP models are good at compensating the whole operation region of the non-linear electronic device and may have the benefit to avoid substantial deterioration due to local unexpected behavior. On the other hand, LUT models can avoid global dependency on local effects. This makes LUT models suitable for strongly amplitude-dependent nonlinearity. For LUT models, overfitting might occur when the model learns the details from noise and nonlinear distortion in training data to the extent that the training negatively impacts the performance of the model on new data. Overfitting might occur with nonparametric nonlinear models such as LUT models in scenarios that have more flexibility when learning a target function. LUT models are more sensitive than GMP models in terms of the overfitting problem.

It is noted that there are other types of models that can be used by the DPD to model the non-linear behavior of the non-linear electronic device, such as pruned Volterra series models, and neural network models. However, the computational complexities of these models are too heavy for practical implementation.

To handle memory effects, filter delays, or just delays for short, are included in the LUT and GMP models. Typically, it is not possible to select all delays in the predefined range, since this may lead to very large dimension in the model. To reduce the dimension, only a few discrete values of the delays are commonly applied. Unfortunately, the correct values of the delays are hidden in the signal processed by the DPD and cannot be found straightforwardly. One task of the DPD is to determine the optimal delays according to the memory effects. Searching of the delays commonly requires comparatively long time.

Currently, some approaches have been proposed for quick delay searching. For instance, least absolute shrinkage and selection operator (LASSO) and principal component analysis (PCA) have been introduced to apply posterior strategies in the DPD for selecting the most appropriate delay values. Moreover, greedy pursuit, a traditional sparsity representation technique in the field of compressed sensing, has been used as part of GMP models. Common greedy pursuit-based methods include orthogonal matching pursuit (OMP), compressive sampling matching pursuit (CoSaMP), subspace pursuit (SP), etc. The computational complexity of greedy pursuit algorithms is too high for practical implementation of online searching for delays, and only feasible for offline searching.

Hence, there is still a need for an improved DPD.

GILABERT PERE LET AL: "Spectral Weighting Orthogonal Matching Pursuit Algorithm for Enhanced Out-of-Band Digital Predistortion Linearization", IEEE TRANSACTIONS ON CIRCUITS AND SYSTEMS II: EXPRESS BRIEFS, IEEE, USA, vol. 66, no. 7, 1 July 2019 (2019-07-01), pages 1277-1281, XP011732420, ISSN: 1549-7747, DOI: 10.1109/

TCSII.2018.2878581 discloses a variant of the orthogonal matching pursuit, OMP, algorithm for reducing the computational complexity of the digital predistortion, DPD, behavioral model in the forward path.

WO 2021/251852 A1 discloses a mechanism for enabling linearization of a non-linear electronic device.

AHBIB NOURA DERRIA ET AL: "Massive MIMO Uplink Channel Estimation using Compressive Sensing", 2019 INTERNATIONAL CONFERENCE ON SOFTWARE, TELECOMMUNICATIONS AND COMPUTER NETWORKS (SOFTCOM), UNIVERSITY OF SPLIT, FESB, 19 September 2019 (2019-09-19), pages 1-6, XP033661895, DOI: 10.23919/

SOFTCOM.2019.8903860 discloses a method for channel estimation in massive Multiple-Input Multiple-Output, MIMO, systems using a block orthogonal matching pursuit, block-OMP, algorithm.

### SUMMARY

An object of embodiments herein is to provide a DPD that does not suffer from the issues disclosed above, or at least where the above disclosed issues have been mitigated or reduced.

According to a first aspect corresponding to the invention as claimed, there is presented a method for operating a DPD for a non-linear electronic device. The method comprises receiving an input signal destined to be input to the non-linear electronic device. The method comprises selecting, for basis functions that represent input-output characteristics of the non-linear electronic device, a set of tap delays. The set of tap delays is selected using a block orthogonal matching pursuit algorithm. The method comprises obtaining an output signal by subjecting the input signal to a linearization function defined by the basis functions with the selected set of tap delays. The method comprises providing the output signal as input to the non-linear electronic device.

According to a second aspect corresponding to the invention as claimed, there is presented a DPD for a non-linear electronic device. The DPD comprises processing circuitry. The processing circuitry is configured to cause the DPD to receive an input signal destined to be input to the non-linear electronic device. The processing circuitry is configured to cause the DPD to select, for basis functions that represent input-output characteristics of the non-linear electronic device, a set of tap delays. The set of tap delays is selected using a block orthogonal matching pursuit algorithm.

The processing circuitry is configured to cause the DPD to obtain an output signal by subjecting the input signal to a linearization function defined by the basis functions with the selected set of tap delays. The processing circuitry is configured to cause the DPD to provide the output signal as input to the non-linear electronic device.

According to a third aspect corresponding to the invention as claimed, there is presented a computer program for operating a DPD for a non-linear electronic device, the computer program comprising computer program code which, when run on a DPD, causes the DPD to perform a method according to the first aspect.

Advantageously, the disclosed DPD does not suffer from the issues noted above.

Advantageously, these aspects enable the tap delays to be selected in a computationally and memory efficient manner.

Advantageously, these aspects can be used to improve the linearization performance of the DPD.

Advantageously, these aspects enable the DPD to have a low power consumption due to only requiring a small number of LUTs (if used).

Other objectives, features and advantages of the enclosed embodiments will be apparent from the following detailed disclosure, from the attached dependent claims as well as from the drawings.

Generally, all terms used in the claims are to be interpreted according to their ordinary meaning in the technical field, unless explicitly defined otherwise herein. All references to "a/an/the element, apparatus, component, means, module, step, etc." are to be interpreted openly as referring to at least one instance of the element, apparatus, component, means, module, step, etc., unless explicitly stated otherwise. The steps of any method disclosed herein do not have to be performed in the exact order disclosed, unless explicitly stated.

### BRIEF DESCRIPTION OF THE DRAWINGS

The inventive concept is now described, by way of example, with reference to the accompanying drawings, in which:
Fig. 1 and Fig. 2 are schematic diagrams illustrating DPDs according to embodiments;
Fig. 3 and Fig. 5 are flowcharts of methods according to embodiments;
Fig. 4 is a block diagram of a DPD with a cascading structure according to embodiments;
Fig. 6 shows simulation results according to embodiments;
Fig. 7 is a schematic diagram showing functional units of a DPD according to an embodiment;
Fig. 8 is a schematic diagram showing functional modules of a DPD according to an embodiment; and
Fig. 9 shows one example of a computer program product comprising computer readable storage medium according to an embodiment.

### DETAILED DESCRIPTION

The inventive concept will now be described more fully hereinafter with reference to the accompanying drawings, in which certain embodiments of the inventive concept are shown. This inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description. Any step or feature illustrated by dashed lines should be regarded as optional.

The embodiments disclosed herein relate to mechanisms for operating a DPD for a non-linear electronic device. In order to obtain such mechanisms there is provided a DPD, a method performed by the DPD, a computer program product comprising code, for example in the form of a computer program, that when run on a DPD, causes the DPD to perform the method.

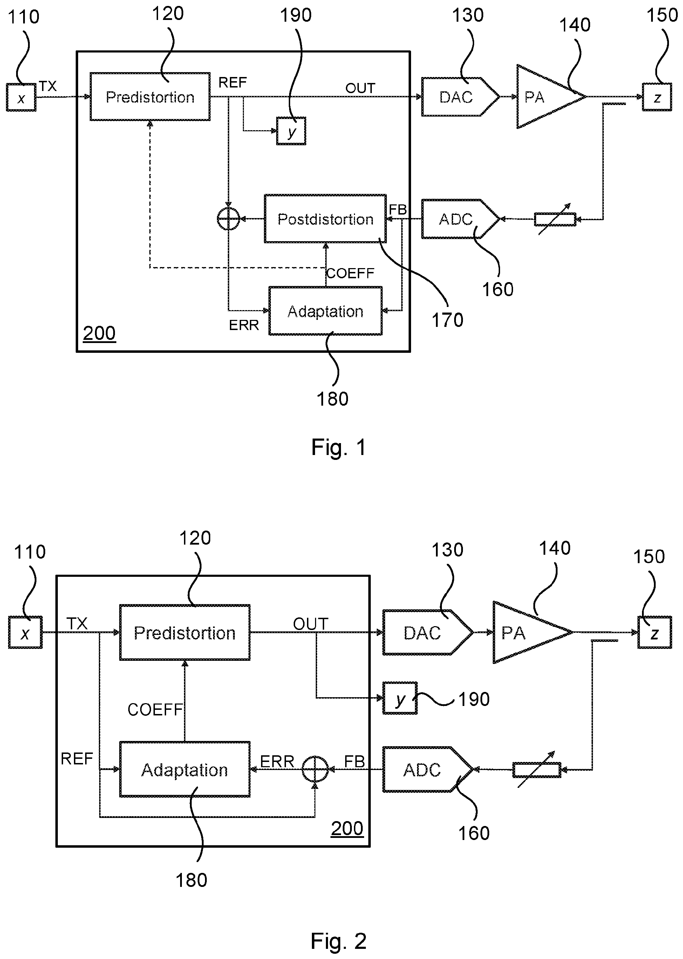

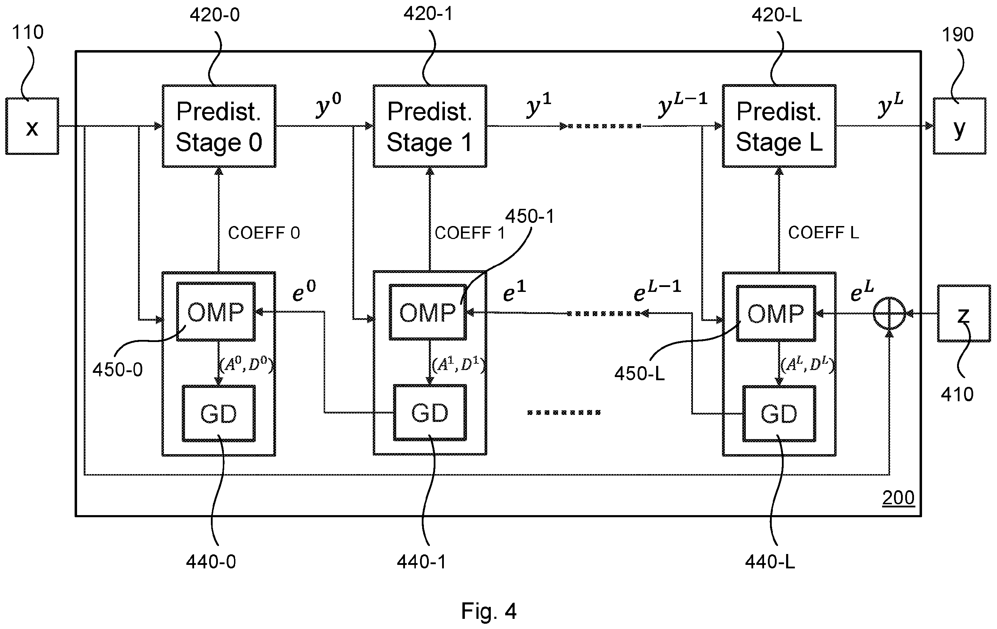

**Fig. 1** shows an example of a DPD 200 based on a so-called indirect-learning architecture (ILA). The DPD 200 is configured to, from a signal source 110, receive an input signal destined to be input to a non-linear electronic device 140 in terms of a PA. In some non-limiting examples, the signal source 110 is a signal modulating entity. The signal modulating entity could be a data modulating device e.g. operating at baseband and which is configured to process signals after being channel filtered and/or limited to some amplitude crest factor. The DPD 200 is operatively connected to the non-linear electronic device via a digital-to-analog converter (DAC) 130 in the forward path and an analog-to-digital converter (ADC) 160 in the feedback path. In a first step, a coefficient is calculated in an adaptation block 180 based on the signal produced by the non-linear electronic device 140 and an error signal ("ERR") taken as a difference between the signal ("REF") produced by the DPD 200 and a signal produced by a postdistortion block 170. In a second step, the resultant coefficient ("COEFF") is copied into the postdistortion block 170, and possible also a predistortion block 120. The signal ("REF") produced by the DPD 200 is collected at block 190 for comparison purposes. The signal produced by the non-linear electronic device 140 is collected at block 150 for comparison purposes. ILA can work at oneshot mode, where the coefficient can be given by only one calculation. Further, ILA can also work in an iterative mode. **Fig. 2** shows an example of a DPD 200 based on a so-called direct-learning architecture (DLA). As in Fig. 1, the DPD 200 is configured to, from a signal source 110, receive an input signal destined to be input to a nonlinear electronic device 140 in terms of a PA and is operatively connected to the nonlinear electronic device 140 via a DAC 130 in the forward path and an ADC 160 in the feedback path. An adaptation block 180 calculates a coefficient ("COEFF") based on the input signal to the DPD 200 as well as an error signal ("ERR") based on a difference between the input signal ("REF") to the DPD 200 and the output signal ("FB") produced by the non-linear electronic device 140. An iterative mode is used where the coefficient is updated gradually until the error takes a desired value. Besides DPDs based on ILA or DLA, there are also DPDs based on structures that connects multiple predistortion blocks together in a cascading chain, thus forming a cascading structure. In such cascading structures, the output of stage *l* connects to the input of stage *l* + 1. Cascading structures can be used for both polynomial terms and memory terms, hence leading to better performance. Meanwhile, each predistortion has its own adaptation block, and all adaptation blocks are also connected, while in a backward direction. The coefficient calculation starts from the last stage (i.e. stage L) and propagates to the first stage (i.e. stage 0). Newton's method or first-order gradient descent (GD) algorithm can be applied inside each adaptation to derive the coefficient. An embodiment where the herein disclosed concept is applied to a cascading structure will be disclosed below with reference to Fig. 4.

The LUT model of Equation (1) can be rewritten as: $y \left(n\right) = {\sum }_{i = 0}^{M} {\sum }_{k = 0}^{K - 1} {F}_{k} \left(\left|x\left(n-{A}_{i}\right)\right|\right) x \left(n-{D}_{i}\right)$ (3)

The GMP model of Equation (2) can be rewritten as: $y \left(n\right) = {\sum }_{i = 0}^{M} {\sum }_{k = 0}^{K - 1} {c}_{i , k} {\left|x\left(n-{A}_{i}\right)\right|}^{k} x \left(n-{D}_{i}\right)$ (4)

In both Equations (3) and (4), *K* denotes the dimension of basis function, *M* denotes the memory depth, and *Aᵢ* and *Dᵢ* are the address delay and data delay for filter tap *i*, respectively. Each of the address delay and the data delay can take a respective discrete value from a large range. The address delay and the data delay can collectively be represented by a tap delay, where the tap delay thus has two components; an address delay and a data delay. How to select proper tap delays will be disclosed next.

The inventors of the herein disclosed inventive concept have realized that the LUT model and the GMP model describe the same DPD characteristics (i.e., the inverse of the non-linear characteristics of the non-linear electronic device 140) but in different ways. For this reason, Equations (3) and (4) can be re-written as to matrix form, namely $y = Xw$ where ***y*, *w*,** and ***X*** denote the output signal, coefficient, and the BF, respectively. Specifically, these variables can be expressed as: $y = {\left[y\left(n\right) y\left(n+1\right) … y\left(n+N-1\right)\right]}^{T}$ $w = {\left[{w}_{0}^{T} {w}_{1}^{T} … {w}_{M}^{T}\right]}^{T}$ $X = \left[\begin{matrix}{X}_{0} \left(n\right) & {X}_{1} \left(n\right) & {X}_{2} \left(n\right) & ⋯ & {X}_{M} \left(n\right) \\ {X}_{0} \left(n+1\right) & {X}_{1} \left(n+1\right) & {X}_{2} \left(n+1\right) & ⋯ & {X}_{M} \left(n+2\right) \\ ⋮ & ⋮ & ⋮ & ⋮ & ⋮ \\ {X}_{0} \left(n+N-1\right) & {X}_{1} \left(n+N-1\right) & {X}_{2} \left(n+N-1\right) & … & {X}_{M} \left(n+N-1\right)\end{matrix}\right]$

For example, ***X**ᵢ*(*n*) can be further expressed as: ${X}_{i} \left(n\right) = \left[{\overline{x}}_{i , 0}\left(n\right) {\overline{x}}_{i , 1}\left(n\right) … {\overline{x}}_{i , K - 1}\left(n\right)\right]$ where *x̅_{i,k}*(*n*) is relevant to the signal *x*(*n*) but the details depend on the model used (i.e., either LUT or GMP).

For the GMP model, the entry *x̅_{i,k}*(*n*) can be expressed as: ${\overline{x}}_{i , k} \left(n\right) = {\left|x\left(n-{A}_{i}\right)\right|}^{k} x \left(n-{D}_{i}\right)$

For the LUT model, assume that the amplitude is uniformly segmented into *P* pieces, and that the resolution of each piece is *R*. The BF also depends on the interpolation function used. For a linear interpolation function, the entry *x̅_{i,k}*(*n*) can be expressed as: ${\overline{x}}_{i , k} \left(n\right) = \left\{\begin{matrix}\left(1-r\right) x \left(n-{D}_{i}\right) , \\ rx \left(n-{D}_{i}\right) , \\ 0 ,\end{matrix} \begin{matrix}k = p \\ k = p + 1 \\ otherwise\end{matrix}\right.$

For a Cubic-Spline interpolation function, the BF can be expressed as: ${\overline{x}}_{i , k} \left(n\right) = \left\{\begin{matrix}\frac{1}{6} \left(-{r}^{3}+3{r}^{2}-2r\right) x \left(n-{D}_{i}\right) , & k = p - 1 \\ \frac{1}{6} \left(3{r}^{3}-6{r}^{2}-3r+6\right) x \left(n-{D}_{i}\right) & k = p \\ \frac{1}{6} \left(-3{r}^{3}+3{r}^{2}+6r\right) x \left(n-{D}_{i}\right) , & k = p + 1 \\ \frac{1}{6} \left({r}^{3}-r\right) x \left(n-{D}_{i}\right) , & k = p + 2 \\ 0 , & otherwise\end{matrix}\right.$ where *p* = floor(|*x*(*n* - *Aᵢ*)|/*R*), *r =* |*x*(*n* - *Aᵢ*)|/*R - p.* It can be seen that *p* is constrained in the interval [0, *P*], and *r* is constrained in the interval [0, 1].

Other interpolation functions, with corresponding expressions for the entry *x̅_{i,k}*(*n*), can be given in the similar way.

As will be disclosed next, a block orthogonal matching pursuit (block-OMP) algorithm is used in order to, with a greedy strategy, identify and select the right tap delays.

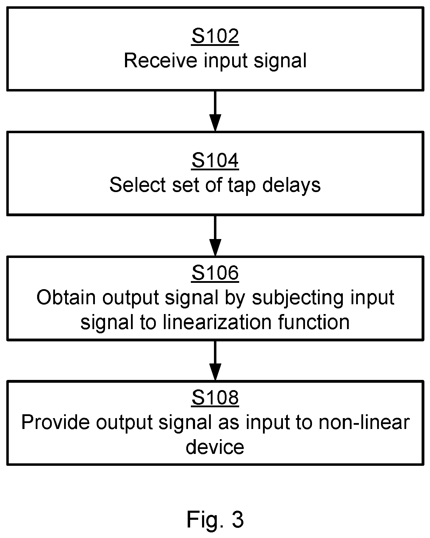

**Fig. 3** is a flowchart illustrating embodiments of methods for operating a DPD 200 for a non-linear electronic device 140. The methods are performed by the DPD 200. The methods are advantageously provided as computer programs 920.

S102: The DPD 200 receives an input signal. The input signal is destined to be input to the non-linear electronic device 140.

S104: The DPD 200 selects, for BFs that represent input-output characteristics of the non-linear electronic device 140, a set of tap delays. The set of tap delays is selected using a block-OMP algorithm.

S106: The DPD 200 obtains an output signal by subjecting the input signal to a linearization function. The linearization function is defined by the BFs with the selected set of tap delays.

S108: The DPD 200 provides the output signal as input to the non-linear electronic device 140.

Embodiments relating to further details of operating the DPD 200 for the non-linear electronic device 140 as performed by the DPD 200 will now be disclosed.

In some aspects, the problem at hand can be rephrased as how to select the best tap delays (with corresponding address delay and data delay) from all candidates tap delays. It is well known that selecting *K* elements from a set of *N* elements is a computationally prohibitive problem. For example, if *M* = 15 and each of the address delay and the data delay independently takes a value in the range [-10:39], then *M* + 1 = 16 values are to be selected out of a total of 2500 values, which mathematically can be expressed as $\left(\begin{matrix}2500 \\ 16\end{matrix}\right)$. Considering that not all tap delays have the same contribution, only the tap delays that have major contributions should be selected.

Therefore, in some embodiments, the selected set of tap delays are selected from a set of available candidate tap delays.

In some aspects, a candidate matrix is constructed that contains all possible tap delays as follows: $X ′ = \left[\begin{matrix}{X}_{0} \left(n\right) & {X}_{1} \left(n\right) & {X}_{2} \left(n\right) & ⋯ & {X}_{M ′} \left(n\right) \\ {X}_{0} \left(n+1\right) & {X}_{1} \left(n+1\right) & {X}_{2} \left(n+1\right) & ⋯ & {X}_{M ′} \left(n+1\right) \\ ⋮ & ⋮ & ⋮ & ⋮ & ⋮ \\ {X}_{0} \left(n+N-1\right) & {X}_{1} \left(n+N-1\right) & {X}_{2} \left(n+N-1\right) & … & {X}_{M ′} \left(n+N-1\right)\end{matrix}\right]$

Each entry in ***X'*** is a row vector with *K* values. *M'* is equivalent to the multiplication of the number of candidate values for *Aᵢ* and the number of candidate values for *Dᵢ*. The target is to select only *M +* 1 tap delays from *M'* + 1 tap delays that are good enough to fulfill a given requirement. Hence, in some embodiments, the set of available candidate tap delays is represented by a matrix, and the selected set of tap delays represents a submatrix extracted from the matrix.

If all candidate values are put into the matrix ***X'***, the matrix might be too large to be stored in available memory. For example, if each of the address delay and the data delay independently takes a value in the range [-10:39], then *M'* = 50 · 50 = 2500. The size of ***X'*** can be reduced. For example, since the value of the address delay commonly is close to the value of the data delay, the value of the data delay can be restricted to only be within a predetermined range of the address delay, for example only within the range [-2:2]. Then, *M'* = 50 · 5 = 250, i.e., only 1/10 of the original size. Hence, in some embodiments, each of the tap delays corresponds to an address delay and a data delay, and one of the address delay and the data delay is restricted to take a value within a predetermined range of the other of the address delay and the data delay. It is here noted that the address delay not necessarily takes the same value as the data delay.

In some aspects, a respective set of tap delays is iteratively selected. In particular, in some embodiments, according to the block-OMP algorithm, the set of tap delays are iteratively selected, and a respective subset of the set of tap delays is selected at each iteration of the block-OMP algorithm.

In some aspects, the tap delays are selected by, in each iteration, finding the submatrix ***Z**ⱼ* in ***X'*** that has largest contribution, i.e., yields highest correlation between the submatrix ***Z**ⱼ* and a residual error signal ***e**ⱼ*. The residual error signal represents the error between the reference signal from the DPD input and the feedback signal from the output of the non-linear electronic device 140. In particular, in some embodiments, the subset of the set of tap delays is selected with an object to yield highest correlation with a residual error signal, where the residual error signal representing an error between a reference signal from the DPD and a feedback signal from the non-linear electronic device 140.

In some aspects, the contribution of the selected submatrix ***Z**ⱼ* is subtracted from the residual error signal ***e**ⱼ*. That is, in some embodiments, for a given iteration, a contribution being a function of the submatrix represented by the subset of tap delays selected for this given iteration is subtracted from the residual error signal.

In some aspects, the remainder matrix is projected onto the orthogonal space of the selected submatrix ***Z**ⱼ*. In particular, in some embodiments, for a given iteration, the matrix represented by the set of available candidate tap delays is projected onto an orthogonal space of the submatrix represented by the subset of tap delays selected for this given iteration.

One possible implementation of the Block-OMP algorithm is provided in Tableaux 1.

**Tableaux 1: Example of Block-OMP algorithm**

| | |
|---|---|
| **1.** At iteration *j* = 0, initialize a remainder matrix as ***Z***_{*j*=0} = ***X'***, and a residual error as ***e***_{*j=*0} *= **y***, and selected tap delays ***s***_{*j*=0} as an empty matrix. Without loss of generalization, the remainder matrix can be expressed as ***Z**ⱼ =* [***Z***_{*j*,0} ***Z***_{*j*,1} ... *Z_{j,M'}*]*.* Each sub-matrix contains all basis functions in one filter tap. The number of sub-matrices, denoted by *M'*, is decreased as the iteration moves on. | |
| **2.** For iteration *j*: | |
| | a. Find the best-so-far submatrix (with *N* rows and *K* columns) in the remainder matrix (i.e., find the index *s** of the submatrix ***Z**ⱼ* that has |
| | largest contribution, i.e., yields highest correlation between selected submatrix ***Z**ⱼ* and the residual error ***e***_{*j*-1}: |
| | $s * = {argmax}_{s} {\left‖{Z}_{j - 1 , s}{\left({Z}_{j - 1 , s}^{H}{Z}_{j - 1 , s}\right)}^{- 1}\left({Z}_{j - 1 , s}^{H}{e}_{j - 1}\right)\right‖}_{2}^{2}$ |
| | b. Add the index s* into the matrix of selected tap delays: |
| | ${s}_{j} = \left[{s}_{j - 1} s*\right]$ |
| | c. Subtract the contribution of the selected submatrix from the residual error: |
| | ${e}_{j} = {e}_{j - 1} - {Z}_{j - 1 , s *} {\left({Z}_{j - 1 , s *}^{H}{Z}_{j - 1 , s *}\right)}^{- 1} \left({Z}_{j - 1 , s *}^{H}{e}_{j - 1}\right)$ |
| | d. Project the remainder matrix onto the orthogonal space of the selected submatrix: |
| | ${Z}_{j} = {Z}_{j - 1} - {Z}_{j - 1 , s *} {\left({Z}_{j - 1 , s *}^{H}{Z}_{j - 1 , s *}\right)}^{- 1} \left({Z}_{j - 1 , s *}^{H}{Z}_{j - 1}\right)$ |
| | e. Remove ***Z***_{*j*-1,*s*'} from ***Z***_{j*-*1} |
| | ${Z}_{j} = \left[{Z}_{j - 1 , 0} … {Z}_{j - 1 , s * - 1} {Z}_{j - 1 , s * + 1} … {Z}_{j - 1 , M ′}\right]$ |
| | f. Update *M': = M'* - 1, *j*: *= j +* 1 |
| Repeat from 2 until *j* = *M,* or the residual error is smaller than a given target. | |

The end-result of the Block-OMP algorithm in Tableaux 1 is a set s* containing the selected tap delays. These tap delays have corresponding values of the address delay and the data delay.

In Step 2.a, since ${Z}_{j - 1 , s}^{H}$ has dimension of *N* × *K,* the complexity of a single operation is (*KN* + *K*³ *+ K*² *+ NK*²)*.* The operation has to run (*M' +* 1) times to find a maximum value. In total, Step 2.a needs (*KN + K*³ *+ K*² *+ NK*²)(*M'* + 1) operations. In Step 2.c, the optimal s* is already found, and hence the complexity is only (*KN + K*³ *+ K*² *+ NK*²) operations. In Step 2.d, ***Z***_{j*-*1} has dimension *N* × *K*(*M' +* 1), the projection of ***Z***_{j*-*1} needs (*KN + K*³ *+ K*² *+ NK*(*M' -* 1)) operations. The value of *M'* is decreased as the number of iterations increases. Accordingly, the complexity is reduced as more and more submatrices have been selected.

It is firstly noted that the BF on one filter tap is treated as a whole, which results in the block processing in the OMP. It is secondly noted that only the indices of the filter taps are of interest, not its coefficient. Accordingly, the coefficient does not need to be explicitly determined. This can also save computations. It is thirdly noted that in conventional OMP algorithms, the error in step 2.c is updated by all selected vectors (previous and current). Generally, each submatrix contains *K* vectors, such as tens or even hundreds of vectors. As number of iterations increases, conventional OMP algorithm will eventually reach prohibitive complexity. However, according to the proposed Block-OMP algorithm, only the currently selected submatrix is utilized to update the error. This significantly reduces the complexity, and the complexity does not increase from one iteration to the next. With respect to step 2.d, since the contribution of all previous selected submatrices has been removed from the remainder matrix, the currently selected submatrix is orthogonal to all previous selected submatrices. As a result, only the currently selected submatrix needs to be considered in the calculation.

The herein disclosed inventive concept can be deployed in DPDs having a cascading structure. That is, in some embodiments, a respective run of the block-OMP algorithm is performed at each of at least two stages of a cascading structure. **Fig. 4** is a block diagram of a DPD 200 with a cascading structure according to herein disclosed embodiments. A DPD 200 with such cascading structure can be used in either of Fig. 1 and Fig. 2. The object is to minimize the normalized mean squared error (NMSE) between the input signal 110 and the input signal 410 at the last stage, i.e. $min \left({\sum }_{n = 0}^{N - 1} {\left|x\left(n\right)-z\left(n\right)\right|}^{2}\right)$. By defining the input error of stage *l* as *e^{l}*(*n*), and the input reference signal of stage *l* as *y*^{*l*-1}(*n*), the coefficient ("COEFF L", "COEFF 1", "COEFF 0") as provided to the predistortion block 420-0, 420-1, 420-L at stage *l* can be derived by *e^{l}*(*n*) and *y*^{*l*-1}(*n*) accordingly. For instance, at stage *l,* the BF matrix can be composed with *y*^{l-1}(*n*), and *e^{l}*(*n*) can be used as the initial error. Then, the Block-OMP algorithm can be applied in each OMP block 450-0, 450-1, 450-L to select the optimal tap delays (with corresponding values of the address delay and the data delay; (*A^{l}, D^{l}*))*.* After that, the delays (*A^{l}, D^{l}*) are fed into the GD algorithm at each GD block 440-0, 440-1, 440-L for coefficient calculation. The resultant error of the GD block at stage *l,* i.e., *e*^{*l*-1}, is then injected into the OMP block of the next stage, i.e. stage *l* - 1. The error is thus propagated from the last stage to the first stage. In particular, in some embodiments, an error produced by running the block-OMP algorithm at stage *l* is propagated back as input to the block-OMP algorithm run at stage *l* - 1. When all coefficients are obtained, they are copied into the predistortion block. The Block-OMP algorithm is performed in each stage in a sequential manner. The Block-OMP algorithm in Tableaux 1 thus represents one main DPD iteration. The main DPD iterations are continued to minimize the NMSE at the output.

In some embodiments, coefficients of the BF and the set of tap delays are alternatingly selected at each of the at least two stages. In this respect, the Block-OMP algorithm and the GD algorithm can be alternatingly executed in each main DPD iteration. Different strategies may have different tradeoff between performance and complexity. For instance, in each main DPD iteration, the Block-OMP algorithm only enables one or more tap delays to be added to the model. As a result, the number of tap delays increases with the main DPD iterations. Specifically, if *mₗ* tap delays are already added by the Block-OMP algorithm for stage *l* in up-to-now DPD iterations, the GD algorithm just needs to compute the coefficient for these *mₗ* tap delays. In total, there are (*m*₀ + ··· + *m_{L}*) tap delays in all actuators, where *mₗ* should be less or equal to *M* + 1, because the maximum number of tap delays is commonly determined by this resource. Furthermore, it is possible to terminate the Block-OMP algorithm earlier when *mₗ* has not yet reached *M* + 1 if the performance is good enough to fulfill the given requirement. This can minimize resource occupation as well as the power consumption. Other strategies of scheduling iterations between the Block-OMP algorithm and the GD algorithm in each main DPD iteration are also possible.

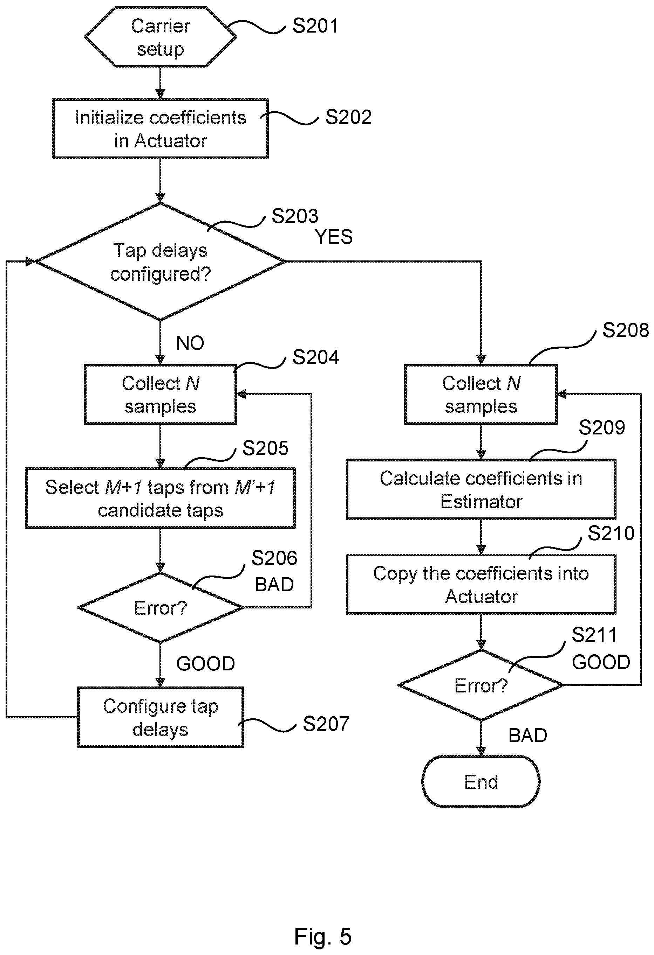

In some embodiments, the non-linear electronic device 140 is a radio transceiver device, such as a (radio) access node, transmission-and-reception (TRP) point, user equipment (UE), or the like, and the set of tap delays is selected in conjunction with carrier set-up being requested for the radio transceiver device. In further detail, owing to the low computational complexity (overhead), of the disclosed Block-OMP algorithm, the Block-OMP algorithm can run on a radio transceiver device to accommodate different carrier configurations. Reference is here made to the flowchart of **Fig. 5****.** When carrier setup is requested (S201), the DPD 200 initializes coefficients in the actuator (S202). The DPD 200 further checks (S203) whether the tap delay is configured. If not configured, the herein disclosed selection of tap delays will be executed. In particular, an input signal with *N* samples is received (S204), *M +* 1 tap delays are selected from *M*' + 1 candidate tap delays (S205). After the tap delays have been selected, the residual error is checked (S206). If the NMSE is worse than the predefined threshold (as indicated by "BAD"), step S204 is entered again. Otherwise (as indicated by "GOOD"), the resultant tap delays are configured (S207) in the actuator and estimator. When tap delays are configured an input signal with *N* samples is received (S208). After required samples are collected, the coefficients are calculated in the estimator (S209), and then the resulting coefficients are copied into the actuator (S210). The residual error is checked (S211) to determine whether the DPD 200 converges to a desired value or not. If the residual error is better than a predefined threshold (as indicated by "GOOD"), the DPD 200 continues operating for a next main DPD iteration. Otherwise (as indicated by "BAD"), the DPD 200 stops its operation and reports a failure to a system controller.

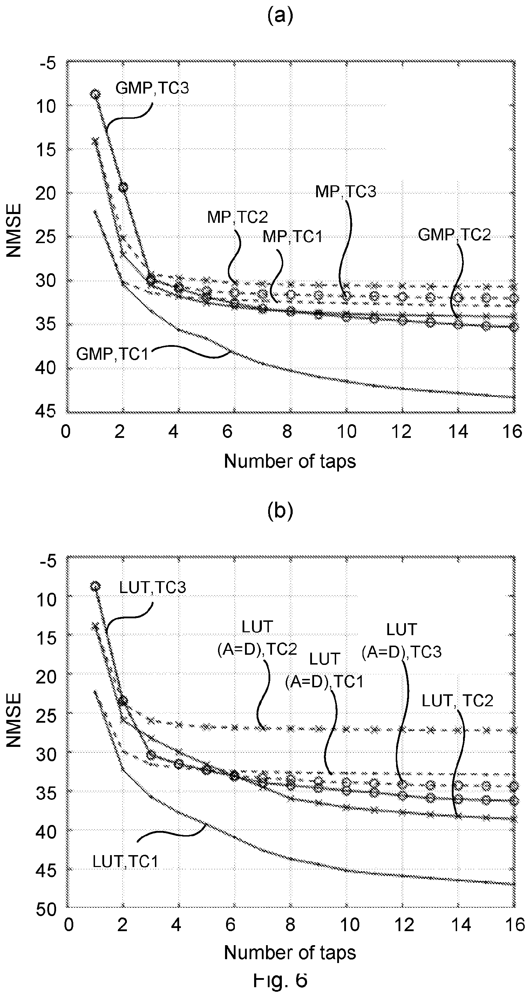

Test results will be revealed next with reference to Figs. 6(a) and 6(b). Each of these figures shows the resultant NMSE with the proposed Block-OMP algorithm in three test cases (TC). Two carriers with proper carrier spacing are setup in the tests. In test case 1 (TC1), a non-linear electronic device 140 in terms of a single-band PA operating at a frequency band "Band 1" with 49dBm average power is tested. In TC2, a non-linear electronic device 140 in terms of a dual-band PA operating at a frequency band "Band 68" and a frequency band "Band 8" with 50dBm average power is tested. In TC3, a non-linear electronic device 140 in terms of a mid-band PA operating at a frequency band "Band n78" (3.4GHz~3.8GHz) with 39dBm average power is tested. The NMSE is checked with tap delays up to *M* = 15. The candidate data delay is configured to be in the interval [-10:39], and the address delay is configured around the data delay.

Focusing first on **Fig. 6(a)****,** two strategies are utilized in the tests. According to the first strategy, the address delay and the data delay are forced to take the same value.

This corresponds to a Memory Polynomials (MP) model. According to the second strategy, the address delay is allowed to be different from the data delay, but only within the range [-2:2] from the data delay. This corresponds to a GMP model. From the results it can be observed that when one more tap delay is added into the model, the resultant NMSE decreases correspondingly. This guarantees that the residual error will always converge to a minimal value. Moreover, it can be observed that the GMP model is always better than the MP model due to the consideration of cross memory terms. This proves the advantages of GMP models over MP models, attributing to the flexibility of delays. It can further be observed that single-band PA with the GMP model reaches lowest NMSE values.

Focusing next on **Fig. 6(b)****,** results are shown for the same test cases as in Fig. 6(a) but for the LUT model. Similarly, there are tap delays where the address delay and the data delay are forced to take the same value. It can be observed that the resultant error of the LUT model is slightly lower than the resultant error of the GMP model. This is because of LUT models can linearize PAs with strong amplitude-dependent behavior. Marginal utility is also found in TC 2 and TC3 where the contribution from an increase is actually reduced as more and more tap delays are already added. This is because the NMSE is limited by the polynomial orders, not by the memory depth. To balance performance and complexity, the number of tap delays should be chosen wisely.

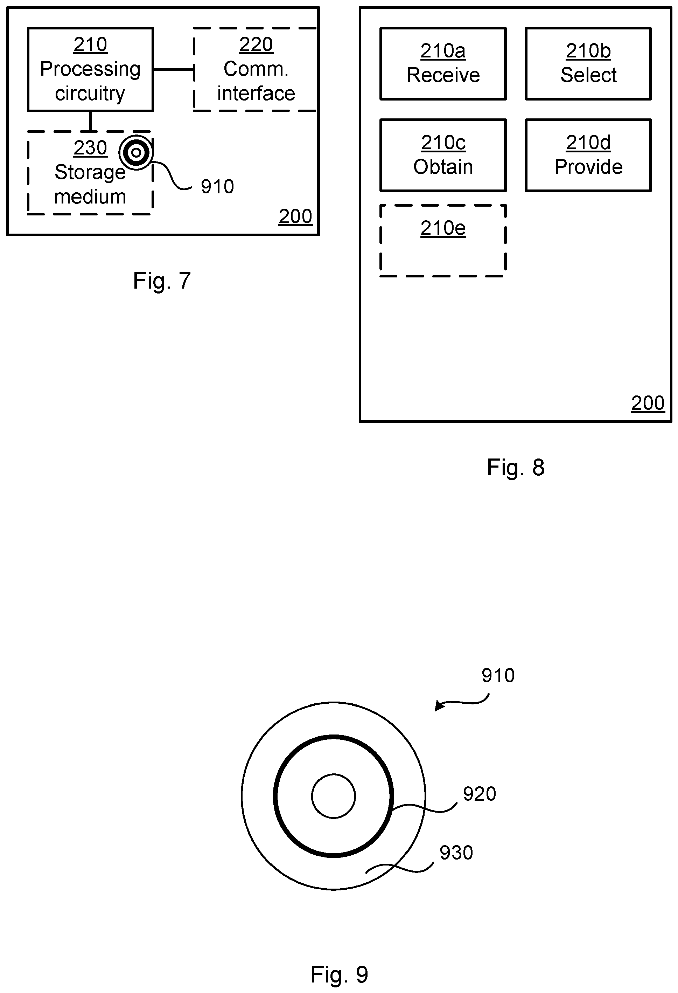

**Fig. 7** schematically illustrates, in terms of a number of functional units, the components of a DPD 200 according to an embodiment. Processing circuitry 210 is provided using any combination of one or more of a suitable central processing unit (CPU), multiprocessor, microcontroller, digital signal processor (DSP), etc., capable of executing software instructions stored in a computer program product 910 (as in Fig. 9), e.g. in the form of a storage medium 230. The processing circuitry 210 may further be provided as at least one application specific integrated circuit (ASIC), or field programmable gate array (FPGA).

Particularly, the processing circuitry 210 is configured to cause the DPD 200 to perform a set of operations, or steps, as disclosed above. For example, the storage medium 230 may store the set of operations, and the processing circuitry 210 may be configured to retrieve the set of operations from the storage medium 230 to cause the DPD 200 to perform the set of operations. The set of operations may be provided as a set of executable instructions.

Thus the processing circuitry 210 is thereby arranged to execute methods as herein disclosed. The storage medium 230 may also comprise persistent storage, which, for example, can be any single one or combination of magnetic memory, optical memory, solid state memory or even remotely mounted memory. The DPD 200 may further comprise a communications interface 220 at least configured for communications with other entities, functions, nodes, and devices. As such the communications interface 220 may comprise one or more transmitters and receivers, comprising analogue and digital components. The processing circuitry 210 controls the general operation of the DPD 200 e.g. by sending data and control signals to the communications interface 220 and the storage medium 230, by receiving data and reports from the communications interface 220, and by retrieving data and instructions from the storage medium 230. Other components, as well as the related functionality, of the DPD 200 are omitted in order not to obscure the concepts presented herein.

**Fig. 8** schematically illustrates, in terms of a number of functional modules, the components of a DPD 200 according to an embodiment. The DPD 200 of Fig. 8 comprises a number of functional modules; a receive module 210a configured to perform step S102, a select module 210b configured to perform step S104, an obtain module 210c configured to perform step S106, and a provide module 210d configured to perform step S108. The DPD 200 of Fig. 8 may further comprise a number of optional functional modules, as represented by functional module 210e. In general terms, each functional module 210a:210e may in one embodiment be implemented only in hardware and in another embodiment with the help of software, i.e., the latter embodiment having computer program instructions stored on the storage medium 230 which when run on the processing circuitry makes the DPD 200 perform the corresponding steps mentioned above in conjunction with Fig 7. It should also be mentioned that even though the modules correspond to parts of a computer program, they do not need to be separate modules therein, but the way in which they are implemented in software is dependent on the programming language used. Preferably, one or more or all functional modules 210a:210e may be implemented by the processing circuitry 210, possibly in cooperation with the communications interface 220 and/or the storage medium 230. The processing circuitry 210 may thus be configured to from the storage medium 230 fetch instructions as provided by a functional module 210a:210e and to execute these instructions, thereby performing any steps as disclosed herein.

The DPD 200 may be provided as a standalone device or as a part of at least one further device. For example, the functionality of the DPD 200 may collocated with the functionality of the non-linear electronic device 140. A first portion of the instructions performed by the DPD 200 may be executed in a first device, and a second portion of the of the instructions performed by the linearizer device 200 may be executed in a second device; the herein disclosed embodiments are not limited to any particular number of devices on which the instructions performed by the DPD 200 may be executed.

**Fig. 9** shows one example of a computer program product 910 comprising computer readable storage medium 930. On this computer readable storage medium 930, a computer program 920 can be stored, which computer program 920 can cause the processing circuitry 210 and thereto operatively coupled entities and devices, such as the communications interface 220 and the storage medium 230, to execute methods according to embodiments described herein. The computer program 920 and/or computer program product 910 may thus provide means for performing any steps as herein disclosed.

In the example of Fig. 9, the computer program product 910 is illustrated as an optical disc, such as a CD (compact disc) or a DVD (digital versatile disc) or a Blu-Ray disc. The computer program product 910 could also be embodied as a memory, such as a random access memory (RAM), a read-only memory (ROM), an erasable programmable read-only memory (EPROM), or an electrically erasable programmable read-only memory (EEPROM) and more particularly as a non-volatile storage medium of a device in an external memory such as a USB (Universal Serial Bus) memory or a Flash memory, such as a compact Flash memory. Thus, while the computer program 920 is here schematically shown as a track on the depicted optical disk, the computer program 920 can be stored in any way which is suitable for the computer program product 910.

The inventive concept has mainly been described above with reference to a few embodiments. However, as is readily appreciated by a person skilled in the art, other embodiments than the ones disclosed above are equally possible within the scope of the inventive concept, as defined by the appended patent claims.

## Claims

1. A method for operating a digital pre-distorter, DPD, (200) for a non-linear electronic device, the method comprising:
receiving (S102) an input signal destined to be input to the non-linear electronic device;
selecting (S104), for basis functions that represent input-output characteristics of the non-linear electronic device, a set of tap delays, wherein the set of tap delays is selected using a block orthogonal matching pursuit, block-OMP, algorithm;
obtaining (S106) an output signal by subjecting the input signal to a linearization function defined by the basis functions with the selected set of tap delays; and
providing (S108) the output signal as input to the non-linear electronic device.

2. The method according to claim 1, wherein the selected set of tap delays are selected from a set of available candidate tap delays.

3. The method according to claim 2, wherein the set of available candidate tap delays is represented by a matrix, and wherein the selected set of tap delays represents a submatrix extracted from the matrix.

4. The method according to any preceding claim, wherein, according to the block-OMP algorithm the set of tap delays are iteratively selected, and wherein a respective subset of the set of tap delays is selected at each iteration of the block-OMP algorithm.

5. The method according to claim 4, wherein the subset of the set of tap delays is selected with an object to yield highest correlation with a residual error signal, the residual error signal representing an error between a reference signal from the DPD and a feedback signal from the non-linear electronic device.

6. The method according to claim 4 or 5, wherein, for a given iteration, a contribution being a function of the submatrix represented by the subset of tap delays selected for said given iteration is subtracted from the residual error signal.

7. The method according to any of claims 4 to 6, wherein, for a given iteration, the matrix represented by the set of available candidate tap delays is projected onto an orthogonal space of the submatrix represented by the subset of tap delays selected for said given iteration.

8. The method according to any preceding claim, wherein each of the tap delays corresponds to an address delay and a data delay, and wherein one of the address delay and the data delay is restricted to take a value within a predetermined range of the other of the address delay and the data delay.

9. The method according to any preceding claim, wherein a respective run of the block-OMP algorithm is performed at each of at least two stages of a cascading structure.

10. The method according to claim 9, wherein coefficients of the basis function and the set of tap delays are alternatingly selected at each of the at least two stages.

11. The method according to any of claims 9 or 10, wherein an error produced by running the block-OMP algorithm at stage *l* is propagated back as input to the block-OMP algorithm run at stage *l* - 1.

12. The method according to any preceding claim, wherein the non-linear electronic device is a radio transceiver device, and wherein the set of tap delays is selected in conjunction with carrier set-up being requested for the radio transceiver device.

13. A digital pre-distorter, DPD, (200) for a non-linear electronic device, the DPD (200) comprising processing circuitry (210), the processing circuitry being configured to cause the DPD (200) to:
receive an input signal destined to be input to the non-linear electronic device;
select, for basis functions that represent input-output characteristics of the nonlinear electronic device, a set of tap delays, wherein the set of tap delays is selected using a block orthogonal matching pursuit, block-OMP, algorithm;
obtain an output signal by subjecting the input signal to a linearization function defined by the basis functions with the selected set of tap delays; and
provide the output signal as input to the non-linear electronic device.

14. The DPD (200) according to claim 13, further being configured to perform the method according to any of claims 2 to 12.

15. A computer program (920) for operating a digital pre-distorter, DPD, (200) for a non-linear electronic device, the computer program comprising computer code which, when run on processing circuitry (210) of the DPD (200), causes the DPD (200) to:
receive (S102) an input signal destined to be input to the non-linear electronic device;
select (S104), for basis functions that represent input-output characteristics of the non-linear electronic device, a set of tap delays, wherein the set of tap delays is selected using a block orthogonal matching pursuit, block-OMP, algorithm;
obtain (S106) an output signal by subjecting the input signal to a linearization function defined by the basis functions with the selected set of tap delays; and
provide (S108) the output signal as input to the non-linear electronic device.

## Patentansprüche

1. Verfahren zum Betreiben eines digitalen Vorverzerrers, DPD, (200), für eine nichtlineare elektronische Vorrichtung, wobei das Verfahren umfasst:
Empfangen (S102) eines Eingabesignals, das dafür bestimmt ist, in die nichtlineare elektronische Vorrichtung eingegeben zu werden;
Auswählen (S104) einer Menge von Abgriffverzögerungen für Basisfunktionen, die Eingabe-Ausgabe-Kennlinien der nichtlinearen elektronischen Vorrichtung darstellen, wobei die Menge von Abgriffverzögerungen unter Verwendung eines Algorithmus mit Block-Orthogonal-Matching-Pursuit, Block-OMP, ausgewählt wird;
Erhalten (S106) eines Ausgabesignals, indem das Eingabesignal einer Linearisierungsfunktion unterzogen wird, die durch die Basisfunktionen mit der ausgewählten Menge von Abgriffverzögerungen definiert ist; und
Bereitstellen (S108) des Ausgabesignals als Eingabe für die nichtlineare elektronische Vorrichtung.

2. Verfahren nach Anspruch 1, wobei die ausgewählte Menge von Abgriffverzögerungen aus einer Menge von verfügbaren Abgriffverzögerungskandidaten ausgewählt wird.

3. Verfahren nach Anspruch 2, wobei die Menge von verfügbaren Abgriffverzögerungskandidaten durch eine Matrix dargestellt wird und wobei die ausgewählte Menge von Abgriffverzögerungen eine aus der Matrix extrahierte Untermatrix darstellt.

4. Verfahren nach einem vorstehenden Anspruch, wobei die Menge von Abgriffverzögerungen gemäß dem Block-OMP-Algorithmus iterativ ausgewählt wird und wobei bei jeder Iteration des Block-OMP-Algorithmus eine jeweilige Teilmenge der Menge von Abgriffverzögerungen ausgewählt wird.

5. Verfahren nach Anspruch 4, wobei die Teilmenge der Menge von Abgriffverzögerungen mit einem Ziel ausgewählt wird, die höchste Korrelation mit einem Restfehlersignal zu erzielen, wobei das Restfehlersignal einen Fehler zwischen einem Referenzsignal vom DPD und einem Rückkopplungssignal von der nichtlinearen elektronischen Vorrichtung darstellt.

6. Verfahren nach Anspruch 4 oder 5, wobei für eine gegebene Iteration ein Beitrag vom Restfehlersignal subtrahiert wird, der eine Funktion der Untermatrix ist, die durch die für die gegebene Iteration ausgewählte Teilmenge von Abgriffverzögerungen dargestellt wird.

7. Verfahren nach einem der Ansprüche 4 bis 6, wobei für eine gegebene Iteration die Matrix, die durch die Menge von verfügbaren Abgriffverzögerungskandidaten dargestellt wird, auf einen orthogonalen Raum der Untermatrix projiziert wird, die durch die für die gegebene Iteration ausgewählte Teilmenge von Abgriffverzögerungen dargestellt wird.

8. Verfahren nach einem vorstehenden Anspruch, wobei jede der Abgriffverzögerungen einer Adressverzögerung und einer Datenverzögerung entspricht und wobei eine der Adressverzögerung und der Datenverzögerung so beschränkt wird, dass sie einen Wert innerhalb eines vorbestimmten Bereichs der anderen der Adressverzögerung und der Datenverzögerung annimmt.

9. Verfahren nach einem vorstehenden Anspruch, wobei in jeder von mindestens zwei Stufen einer Kaskadenstruktur ein jeweiliger Durchlauf des Block-OMP-Algorithmus durchgeführt wird.

10. Verfahren nach Anspruch 9, wobei in jeder der mindestens zwei Stufen abwechselnd Koeffizienten der Basisfunktion und die Menge von Abzweigverzögerungen ausgewählt werden.

11. Verfahren nach einem der Ansprüche 9 oder 10, wobei ein durch die Ausführung des Block-OMP-Algorithmus in Stufe 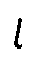 erzeugter Fehler als Eingabe in den in Stufe 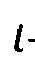 -1 ausgeführten Block-OMP-Algorithmus zurückgeführt wird.

12. Verfahren nach einem vorstehenden Anspruch, wobei die nichtlineare elektronische Vorrichtung ein Funk-Sender/Empfänger ist und wobei die Menge von Abgriffverzögerungen in Verbindung damit ausgewählt wird, dass die Einrichtung eines Trägers für den Sendeempfänger angefordert wird.

13. Digitaler Vorverzerrer, DPD, (200) für eine nichtlineare elektronische Vorrichtung, wobei der DPD (200) eine Verarbeitungsschaltung (210) umfasst, wobei die Verarbeitungsschaltung dafür konfiguriert ist, den DPD (200) dazu zu veranlassen:
ein Eingabesignal zu empfangen, das dafür bestimmt ist, in die nichtlineare elektronische Vorrichtung eingegeben zu werden;
für Basisfunktionen, die Eingabe-Ausgabe-Kennlinien der nichtlinearen elektronischen Vorrichtung darstellen, eine Menge von Abgriffverzögerungen auszuwählen, wobei die Menge von Abgriffverzögerungen unter Verwendung eines Algorithmus mit Block-Orthogonal-Matching-Pursuit, Block-OMP, ausgewählt wird;
ein Ausgabesignal zu erhalten, indem das Eingabesignal einer Linearisierungsfunktion unterzogen wird, die durch die Basisfunktionen mit der ausgewählten Menge von Abgriffverzögerungen definiert ist; und
das Ausgabesignal als Eingabesignal für die nichtlineare elektronische Vorrichtung bereitzustellen.

14. DPD (200) nach Anspruch 13, der ferner dafür konfiguriert ist, das Verfahren nach einem der Ansprüche 2 bis 12 durchzuführen.

15. Computerprogramm (920) zum Betreiben eines digitalen Vorverzerrers, DPD, (200) für eine nichtlineare elektronische Vorrichtung, wobei das Computerprogramm Computercode umfasst, der, wenn er auf einer Verarbeitungsschaltung (210) des DPD (200) ausgeführt wird, den DPD (200) dazu veranlasst:
ein Eingabesignal zu empfangen (S102), das dafür bestimmt ist, in die nichtlineare elektronische Vorrichtung eingegeben zu werden;
für Basisfunktionen, die Eingabe-Ausgabe-Kennlinien der nichtlinearen elektronischen Vorrichtung darstellen, eine Menge von Abgriffverzögerungen auszuwählen (S104), wobei die Menge von Abgriffverzögerungen unter Verwendung eines Algorithmus mit Block-Orthogonal-Matching-Pursuit, Block-OMP, ausgewählt wird;
ein Ausgabesignal zu erhalten (S106), indem das Eingabesignal einer Linearisierungsfunktion unterzogen wird, die durch die Basisfunktionen mit der ausgewählten Menge von Abgriffverzögerungen definiert ist; und
das Ausgabesignal als Eingabesignal für die nichtlineare elektronische Vorrichtung bereitzustellen (S108).

## Revendications

1. Procédé de fonctionnement d'un générateur de prédistorsion numérique, DPD, (200) pour un dispositif électronique non linéaire, le procédé comprenant :
la réception (S102) d'un signal d'entrée destiné à être entré dans le dispositif électronique non linéaire ;
la sélection (S104), pour des fonctions de base qui représentent des caractéristiques d'entrée-sortie du dispositif électronique non linéaire, d'un ensemble de retards de prise, dans lequel l'ensemble de retards de prise est sélectionné à l'aide d'un algorithme de poursuite appariée orthogonale par blocs, block-OMP ;
l'obtention (S106) d'un signal de sortie en soumettant le signal d'entrée à une fonction de linéarisation définie par les fonctions de base avec l'ensemble sélectionné de retards de prise ; et
la fourniture (S108) du signal de sortie comme entrée au dispositif électronique non linéaire.

2. Procédé selon la revendication 1, dans lequel l'ensemble sélectionné de retards de prise est sélectionné parmi un ensemble de retards de prise candidats disponibles.

3. Procédé selon la revendication 2, dans lequel l'ensemble de retards de prise candidats disponibles est représenté par une matrice, et dans lequel l'ensemble sélectionné de retards de prise représente une sous-matrice extraite de la matrice.

4. Procédé selon une quelconque revendication précédente, dans lequel, selon l'algorithme block-OMP, l'ensemble de retards de prise est sélectionné de manière itérative, et dans lequel un sous-ensemble respectif de l'ensemble de retards de prise est sélectionné à chaque itération de l'algorithme block-OMP.

5. Procédé selon la revendication 4, dans lequel le sous-ensemble de l'ensemble de retards de prise est sélectionné dans le but d'obtenir une corrélation la plus élevée avec un signal d'erreur résiduelle, le signal d'erreur résiduelle représentant une erreur entre un signal de référence issu du DPD et un signal de rétroaction issu du dispositif électronique non linéaire.

6. Procédé selon la revendication 4 ou 5, dans lequel, pour une itération donnée, une contribution qui est une fonction de la sous-matrice représentée par le sous-ensemble de retards de prise sélectionné pour ladite itération donnée est soustraite du signal d'erreur résiduelle.

7. Procédé selon l'une quelconque des revendications 4 à 6, dans lequel, pour une itération donnée, la matrice représentée par l'ensemble de retards de prise candidats disponibles est projetée sur un espace orthogonal de la sous-matrice représentée par le sous-ensemble de retards de prise sélectionné pour ladite itération donnée.

8. Procédé selon une quelconque revendication précédente, dans lequel chacun des retards de prise correspond à un retard d'adresse et à un retard de données, et dans lequel un retard parmi le retard d'adresse et le retard de données est limité à prendre une valeur dans une plage prédéterminée de l'autre retard parmi le retard d'adresse et le retard de données.

9. Procédé selon une quelconque revendication précédente, dans lequel une exécution respective de l'algorithme block-OMP est effectuée à chaque étage parmi au moins deux étages d'une structure en cascade.

10. Procédé selon la revendication 9, dans lequel des coefficients de la fonction de base et l'ensemble de retards de prise sont sélectionnés alternativement à chaque étage parmi les au moins deux étages.

11. Procédé selon l'une quelconque des revendications 9 ou 10, dans lequel une erreur produite par l'exécution de l'algorithme block-OMP à l'étage 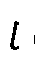 est propagée en retour comme entrée pour l'algorithme block-OMP exécuté à l'étage 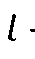 - 1.

12. Procédé selon une quelconque revendication précédente, dans lequel le dispositif électronique non linéaire est un émetteur-récepteur radio, et dans lequel l'ensemble de retards de prise est sélectionné en conjonction avec une configuration de porteuse demandée pour l'émetteur-récepteur radio.

13. Générateur de prédistorsion numérique, DPD, (200) pour un dispositif électronique non linéaire, le DPD (200) comprenant un circuit de traitement (210), le circuit de traitement étant configuré pour amener le DPD (200) à :
recevoir un signal d'entrée destiné à être entré dans le dispositif électronique non linéaire ;
sélectionner, pour des fonctions de base qui représentent des caractéristiques d'entrée-sortie du dispositif électronique non linéaire, un ensemble de retards de prise, dans lequel l'ensemble de retards de prise est sélectionné à l'aide d'un algorithme de poursuite appariée orthogonale par blocs, block-OMP ;
obtenir un signal de sortie en soumettant le signal d'entrée à une fonction de linéarisation définie par les fonctions de base avec l'ensemble sélectionné de retards de prise ; et
fournir le signal de sortie comme entrée au dispositif électronique non linéaire.

14. DPD (200) selon la revendication 13, configurée en outre pour effectuer le procédé selon l'une quelconque des revendications 2 à 12.

15. Programme informatique (920) pour faire fonctionner un générateur de prédistorsion numérique, DPD, (200) pour un dispositif électronique non linéaire, le programme informatique comprenant un code informatique qui, lorsqu'il est exécuté sur un circuit de traitement (210) du DPD (200), amène le DPD (200) à :
recevoir (S102) un signal d'entrée destiné à être entré dans le dispositif électronique non linéaire ;
sélectionner (S104), pour des fonctions de base qui représentent des caractéristiques d'entrée-sortie du dispositif électronique non linéaire, un ensemble de retards de prise, dans lequel l'ensemble de retards de prise est sélectionné à l'aide d'un algorithme de poursuite appariée orthogonale par blocs, block-OMP ;
obtenir (S106) un signal de sortie en soumettant le signal d'entrée à une fonction de linéarisation définie par les fonctions de base avec l'ensemble sélectionné de retards de prise ; et
fournir (S108) le signal de sortie comme entrée au dispositif électronique non linéaire.
